# FASCICULE DE BREVET EUROPEEN

(11) **EP 4 280 463 B1**
(45) Date de publication et mention de la délivrance du brevet: **17.09.2025**
(21) Numéro de dépôt: 23173386.6
(22) Date de dépôt: 15.05.2023
(51) Int. Cl.: H03K 17/97, H01H 1/00

(54) **BOUTON POUSSOIR MAGNÉTIQUE**
MAGNETISCHER DRUCKKNOPF
MAGNETIC PUSH BUTTON

(30) Priorité: 17.05.2022 FR 2204661
(43) Date de publication de la demande: 22.11.2023
(73) Titulaire: THALES, 92400 Courbevoie (FR)
(72) Inventeur: BESNARD, Mathieu, 33700 MERIGNAC (FR)
(74) Mandataire: Lavoix

(56) Documents cités:
- WO-A1-2019/091611
- CH-A5- 669 076
- GB-A- 2 149 961
- US-A- 3 622 922

## Description

La présente invention concerne un bouton poussoir magnétique, appelé également commutateur magnétique à poussoir.

Plus particulièrement, la présente invention concerne le domaine des commutateurs à poussoir mono-fonction, ou à une fonction redondée ou sécurisée, destinés à l'enclenchement de fonctions critiques. Avantageusement, un tel bouton est utilisable dans le domaine aéronautique, par exemple dans un cockpit de pilotage d'un aéronef.

Ce type de commutateurs électriques destinés à l'enclenchement de fonctions critiques, utilisés par exemple sur les planches de bord d'aéronefs, doivent répondre à un certain nombre de contraintes. Notamment, certaines fonctions requièrent que leur mise en opération soit effectuée via une pression sur un commutateur redondé ou sécurisé d'un point de vue électrique, c'est-à-dire établissant simultanément le contact électrique pour au moins deux circuits électriques mettant par exemple en œuvre une fonction unique, les deux circuits électriques ne présentant pas de mode électrique commun.

C'est par exemple le cas, dans des aéronefs, pour des commutateurs d'enclenchement d'un dispositif de pilote automatique (PA). Pour de telles applications, il est également préférable que les commutateurs disposés sur la planche de bord soient de structure compacte. En outre, il est souhaitable que la sensation tactile procurée à un utilisateur par le commutateur lors d'une action sur celui-ci soit agréable, et restitue une information en retour permettant à l'utilisateur de confirmer le bon aboutissement de l'action initiée. L'effort de poussée pour un tel commutateur doit être entre de 0,5 à 20 N (typiquement 5 N). Afin de permettre sa certification, le commutateur poussoir doit également pouvoir répondre à des niveaux de sécurité DAL (de l'anglais *« Design Assurance Level* ») élevés, notamment au niveau DAL A. Dans un tel dispositif, on cherche à générer un agrément de manœuvre (ou sensation tactile) qui a pour fonction principale de garantir que la détection électrique (pour la validation) est assurée après le passage d'un pic d'effort (effort de crantage). Pour une bonne sensation tactile, il est nécessaire que la course du bouton puisse être importante, par exemple supérieure ou égale à 0,3 mm.

En particulier, en ce qui concerne la compacité, un commutateur magnétique à poussoir peut présenter les dimensions suivantes :
- hauteur (dimension suivant la direction du mouvement) : entre 5 et 20 mm (typiquement : 12 mm) ;
- largueur : entre 10 et 38 mm (jusqu'à 70 mm dans certains cas, typiquement : 14 mm) ;
- longueur : entre 10 et 38 mm (jusqu'à 70 mm dans certains cas, typiquement : 14 mm).

Ces dimensions peuvent par exemple être déterminées selon la norme de type MIL-STD-1472.

### ÉTAT DE LA TECHNIQUE

Pour répondre aux besoin précités, il existe des solutions électromécaniques à base de dômes (ou équivalent). Ces solutions demeurent toutefois des assemblages complexes constitués de nombreuses pièces de grande précision. Les dômes sont exposés aux risques de fatigue et de corrosion de contact (en anglais « fretting corrosion ») ce qui limite la durée de vie du dispositif. De plus, la course d'un interrupteur à dôme est rarement supérieure à 0,3 mm. Ces commutateurs ne répondent donc pas à toutes les exigences du besoin.

On connait également des solutions magnéto-mécaniques qui assurent une détection d'activation par des effets magnétiques et un effort de poussée et/ou de rappel par un élément élastique, tel qu'un ressort. Toutefois, un tel élément élastique présente des risques de fatigue et de blocage ou de décalage ce qui limite également la durée de vie du dispositif. CH669076 A5 et US3622922 A décrivent également chacun un bouton poussoir.

### RÉSUMÉ DE L'INVENTION

La présente invention a pour but de proposer un bouton poussoir magnétique répondant à l'ensemble des besoins précités, tout en présentant une fonction de détection, un effort de poussée et éventuellement un effort de rappel sans friction et sans usure, avec un nombre de pièces limité, un montage simplifié et des risques diminués de blocage et de décalage.

À cet effet, l'invention concerne un bouton poussoir magnétique comprenant un corps fixe et un corps mobile par rapport au corps fixe selon un axe de mouvement ;

L'un des corps, dit premier corps, comprend un élément magnétique s'étendant selon l'axe de mouvement et définissant une alternance magnétique selon cet axe de mouvement.

L'autre corps, dit deuxième corps comprend une dent de crantage en matériau ferromagnétique ou magnétique disposée en regard de l'élément magnétique par rapport à un plan parallèle à l'axe du mouvement pour créer un effort de poussée par coopération magnétique avec l'élément magnétique, lors d'un mouvement du corps mobile selon l'axe de mouvement et un détecteur magnétique disposé en regard de l'élément magnétique et configuré pour générer des mesures quantifiant chaque mouvement du corps mobile selon l'axe de mouvement.

Muni de ces caractéristiques, le bouton poussoir selon l'invention permet en effet de mettre en œuvre une fonction de détection et un effort de poussée qui sont créés par le même effet magnétique entre le corps mobile et le corps fixe. Ainsi, l'arrangement de ces deux corps peut être choisi de sorte à minimiser leur contact mécanique donc l'usure. Par exemple, les éléments détaillés ci-dessus du corps fixe et du corps mobile présentent un contact minimal nécessaire pour assurer le mouvement de l'un des corps par rapport à l'autre. Ainsi, ces éléments fonctionnent sensiblement sans friction et sans usure mécanique prématurée. Cela garantit donc la fiabilité à l'usage du bouton et rallonge considérablement sa durée de vie même lorsque des pièces en plastique sont utilisées. De plus, ces éléments sont en nombre limité ce qui permet de les disposer facilement au sein des corps correspondants.

Cela fait alors le montage du bouton particulièrement simple et diminue les risques de blocage et de décalage de différentes pièces entre elles.

Selon certains modes de réalisation de l'invention l'élément magnétique définit au moins un cran central et deux crans périphériques et une position stable en translation étant définie lorsque la dent de crantage est disposée en regard du cran central.

Grâce à ces caractéristiques, l'élément magnétique a trois alternances magnétiques et la dent de crantage ont préférentiellement une aimantation qui permet une attraction avec le cran central de l'élément magnétique. Cela crée par conséquent une position stable centrée au milieu de la course du bouton poussoir qui dispose intrinsèquement d'un retour à cette position stable par rappel magnétique sans contact. L'intérêt de cet arrangement magnétique est d'éviter l'usure et l'usage, dans les deux sens de translation, de tout élément élastique pour assurer un effort de rappel.

Selon certains modes de réalisation de l'invention l'alternance magnétique de l'élément magnétique définit un pas de crantage.

Grâce à ces caractéristiques, la position stable est positionnée sur le cran central de et le profil de force du push démarre sensiblement à 0 N sans pré-charge (cible pour un profil de force à sensation tactile améliorée).

Selon certains modes de réalisation de l'invention la surface de la dent de crantage présente une étendue inférieure ou égale au pas de crantage de l'élément magnétique.

Grâce à ces caractéristiques, l'alternance magnétique de l'élément magnétique correspond à la taille de la dent de crantage et définit la course en translation du bouton poussoir. Cette course en translation est par exemple supérieure ou égale à 0,3 mm. Muni de ces caractéristiques, le nombre de dents peut ainsi être augmenté jusqu'à atteindre le nombre d'alternances magnétiques de 41. Cela permet alors d'optimiser l'effort de crantage ou du push.

Selon certains modes de réalisation de l'invention, présentant un profil de détection d'activation du bouton en fonction des mesures générées par le détecteur magnétique ; ledit profil de détection comprenant une détection d'activation du bouton avec un décalage par rapport à un pic de l'effort de poussée créé par coopération magnétique de l'élément magnétique avec la dent de crantage.

Ces caractéristiques permettent d'assurer une sensation tactile améliorée. En particulier, dans un tel cas, on cherche à générer une sensation tactile qui a pour fonction principale de garantir que la détection d'activation est assurée après le passage d'un pic d'effort (effort de poussée). Cela correspond à une sensation tactile habituellement ressentie par l'utilisateur lors de l'activation d'un bouton poussoir conventionnel.

Selon certains modes de réalisation de l'invention ledit décalage dans le profil de détection est atteint par un décalage le long de l'axe de mouvement du détecteur magnétique et de la dent de crantage.

Grâce à ces caractéristiques, le décalage entre le pic de l'effort de poussée et la détection de l'activation du bouton peut être atteint de manière particulièrement simple. En effet, le détecteur magnétique peut être simplement légèrement décalé le long de l'axe de mouvement par rapport à la dent de crantage ce qui assure une détection légèrement décalée par rapport au pic de l'effort de poussée.

Selon certains modes de réalisation de l'invention le deuxième corps comprend une pluralité de dents de crantage et/ou une pluralité de détecteurs réparties de manière équidistante selon l'axe de mouvement et/ou autour de l'axe de mouvement.

Grâce à ces caractéristiques, l'augmentation du nombre de dents de crantage permet d'augmenter l'effort de poussée souhaité. Cette augmentation peut être faite simultanément avec l'augmentation de la superficie en regard de l'élément magnétique ou alors avec l'augmentation du nombre de différentes parties de l'élément magnétique.

Selon certains modes de réalisation de l'invention le ou chaque dent de crantage et/ou l'élément magnétique est (sont) monté(e)(s) sur un support magnétique ou ferromagnétique.

Ces caractéristiques permettent d'éviter les fuites de champs et les émissions parasites externes, sans augmenter la taille de l'élément correspondant. Par conséquent, ces caractéristiques permettent d'optimiser l'effort de crantage ou du push.

Selon certains modes de réalisation, le premier corps est le corps mobile et le deuxième corps est le corps fixe.

Dans un tel cas, le détecteur magnétique et la dent de crantage restent fixes. Cela est avantageux dans la mesure où le câble électrique issu notamment du détecteur magnétique reste fixe par rapport au corps du bouton. Cela évite un câblage compliqué qui est généralement coûteux et présente des risques d'usure et de coupure du signal.

Selon certains modes de réalisation de l'invention, une butée de course pour chaque fin de course lors du mouvement le long de l'axe de mouvement.

Chaque butée peut être de nature mécanique (i.e. contact mécanique) ou alors magnétique. Dans ce dernier cas, une telle butée peut comprendre des aimants en répulsion en fin de course.

Selon certains modes de réalisation de l'invention comprenant en outre une surface destinée à être orientée vers un opérateur ; ladite surface comprenant au moins un élément fonctionnel choisi dans la liste comprenant :
- un élément de retour visuel ;
- un capteur de présence ;
- un actionneur haptique.

Grâce à ces caractéristiques, il est possible d'assurer un certain nombre de fonctionnalités supplémentaires du bouton. Par exemple, il est possible de mettre en œuvre un retour visuel indiquant par exemple à l'opérateur l'état courant de la fonction associée au bouton (activée ou désactivée) ou toute autre information utile, telle que par exemple la fonction affectée au bouton.

Grâce au capteur de présence il est possible par exemple d'activer des fonctions complémentaires du bouton en détectant la position des doigts sur le bouton. Par exemple, les fonctionnalités du bouton peuvent différer en fonction du nombre de doigts posés sur le bouton.

Grâce à un actionneur haptique il est possible d'améliorer le ressenti haptique par l'utilisateur.

Selon certains modes de réalisation de l'invention comprenant en outre un contrôleur d'effort complémentaire comprenant une bobine électromagnétique solidaire de l'un des corps et configurée pour agir sur la ou chaque dent de crantage et/ou sur l'élément magnétique et/ou sur un support ferromagnétique ou magnétique.

Grâce à ces caractéristiques, il est possible d'augmenter l'effort de poussée ressenti par l'opérateur.

Selon certains modes de réalisation de l'invention, le bouton comprend en outre un switch électromécanique ou opto-mécanique supplémentaire placé au centre du deuxième corps et configuré pour être activé par une tige solidaire du premier corps.

Grâce à ces caractéristiques, il est possible d'augmenter le niveau de sécurité du dispositif grâce au switch formant un détecteur de technologie différente en comparaison avec le détecteur magnétique. Un tel détecteur peut par exemple former un détecteur dit à « contact sec » (i.e. à contact de nature mécanique) ou encore, un détecteur optique.

### DESCRIPTION DES FIGURES

Ces caractéristiques et avantages de l'invention apparaitront à la lecture de la description qui va suivre donnée uniquement à titre d'exemple et non limitatif, et faite en référence aux dessins annexés, sur lesquels :
- [Fig.1] la figure 1 est une vue schématique en perspective d'un bouton poussoir selon un premier mode de réalisation de l'invention ;
- [Fig.2] la figure 2 est une vue en perspective éclatée du bouton de la figure 1 ;
- [Fig.3] la figure 3 présente une vue en coupe selon le plan III de la figure 1 ;
- [Fig.4] la figure 4 est une vue en perspective des éléments internes fonctionnels du corps fixe et du corps mobile de la figure 1, lesdits éléments comprenant notamment un élément magnétique ;
- [Fig.5] la figure 5 est un diagramme de rayonnement magnétique selon différents exemples d'arrangement interne de l'élément magnétique de la figure 4 ;
- [Fig.6] la figure 6 est une vue analogue à celle de la figure 3, le bouton poussoir étant selon un autre exemple de réalisation ;
- [Fig. 7] la figure 7 est une vue de dessus du bouton poussoir de la figure 6.
- [Fig. 8] la figure 8 est une vue analogue à celle de la figure 2, le bouton poussoir étant selon un deuxième mode de réalisation de l'invention ;
- [Fig. 9] la figure 9 est une vue en coupe longitudinale du bouton poussoir de la figure 8 et en coupe transversale selon les flèches E-E sur cette même figure ; et
- [Fig. 10] la figure 10 est une vue en coupe d'un bouton poussoir selon le deuxième mode de réalisation de l'invention selon un exemple différent de celui de la figure 8.

### DESCRIPTION DÉTAILLÉE DE L'INVENTION

### PREMIER MODE DE RÉALISATION

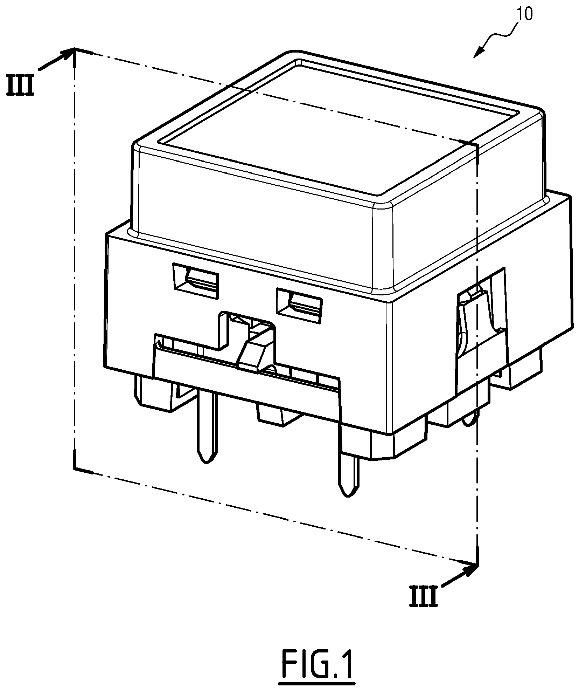

La figure 1 illustre en effet un bouton poussoir magnétique 10 selon le premier mode de réalisation de l'invention. De préférence, le bouton 10 est monté dans un cockpit permettant de piloter un aéronef.

Par « aéronef », on entend tout engin volant, tel qu'un avion, un hélicoptère ou un drone par exemple. Un tel aéronef peut être piloté directement à partir de celui-ci. Dans un tel cas, le cockpit est avantageusement arrangé à l'intérieur de l'aéronef. Selon un autre exemple de réalisation, un tel aéronef est contrôlé à distance. Dans un tel cas, le cockpit est disposé à distance de l'aéronef et présente par exemple une station au sol. Dans tous les cas, l'aéronef est configuré pour être piloté par un opérateur, appelé également utilisateur, par exemple par un pilote à partir du cockpit disposé à l'intérieur de l'aéronef.

Selon l'invention, le bouton 10 permet à l'opérateur de contrôler au moins une fonctionnalité avionique. Par exemple, un tel bouton 10 peut être utilisé par l'opérateur pour contrôler un système avionique et fait partie d'un système de contrôle d'un tel système avionique. En variante, le bouton 10 fait partie d'un système de contrôle de plusieurs systèmes avioniques. Par exemple, le bouton 10 selon l'invention fait partie d'un système dit « Flight Control Unit » (FCU) ou « Integrated Standby Instrument System » (ISIS) ou « Closer Control Device » (CCD) ou « Keyboard Cursor Control Device » (KCCD), etc.

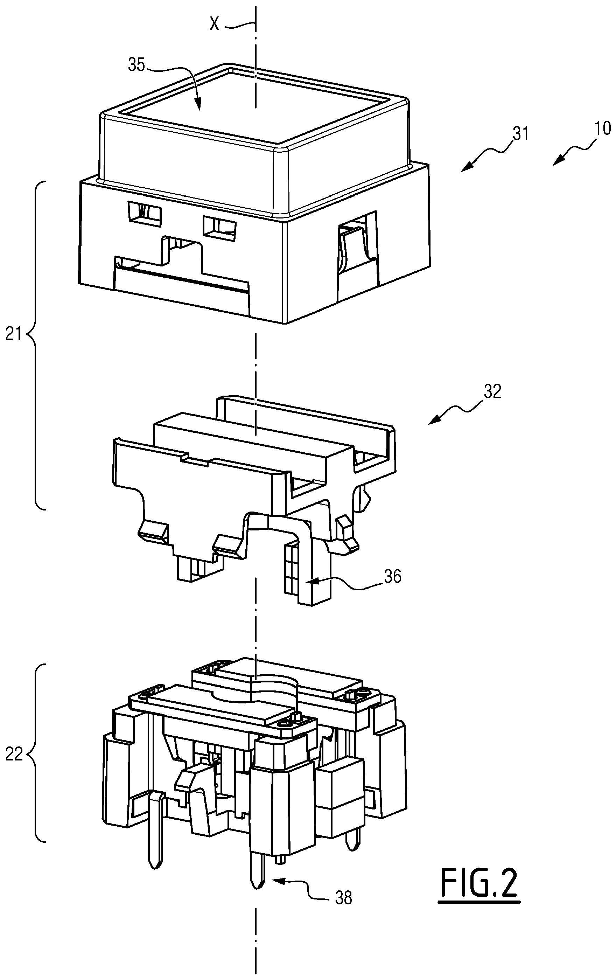

En référence à la figure 2, le bouton 10 comprend un corps mobile 21, appelé également dans l'exemple de cette figure premier corps, et un corps fixe 22, appelé également dans l'exemple de cette figure deuxième corps. Le corps mobile 21 est mobile en translation par rapport au corps fixe 22 le long d'un axe de mouvement X visible également sur la figure 2.

Le corps mobile 21 comprend un capot 31 et un élément d'interconnexion 32. Le capot 31 permet de protéger l'ensemble des éléments internes du bouton 10 et comprend notamment une surface visible 35 destinée à être orientée vers l'opérateur. Selon différents modes de réalisation, le capot 31 peut comprendre des moyens de liaison lui permettant de coopérer avec le corps fixe 22 lors de son mouvement le long de l'axe de mouvement X. Selon d'autres modes de réalisation, ces moyens de liaison font partie de l'élément d'interconnexion 32. Les moyens de liaison assurent par exemple une liaison glissière ou pivot glissante le long de l'axe de mouvement X. Cette liaison peut être :
- des paliers lisses (exemple paliers en polymère ou paliers bronze frittés) préférentiellement à collerettes pour servir de butée mécanique ;
- des paliers à éléments roulants (exemple : douilles à billes) ;
- des liaisons à surfaces planes (exemple : queue d'aronde).

En variante ou en complément, au moins certains de ces moyens de liaison sont intégrés dans le corps fixe 22.

En variante ou en complément, les moyens de liaison entre les corps 21 et 22 peuvent être un corps élastique avec une raideur équivalente. La raideur peut être différente en fonction des directions, par exemple faible suivant l'axe X et forte suivant les autres directions afin de contrer les couples parasites lorsque l'on attaque le bouton de biais. Ce type de liaison peut ainsi être sans contact ni roulement entre les corps 21 et 22. Ce type de liaison peut être :
- une (ou plusieurs) membrane(s) (exemple : plaques en CuBe2 ou membrane en élastomère).
- une (ou plusieurs) pièce(s) déformable(s) plaqué(s) placée(s) au centre (ou autour des corps 21 et 22).

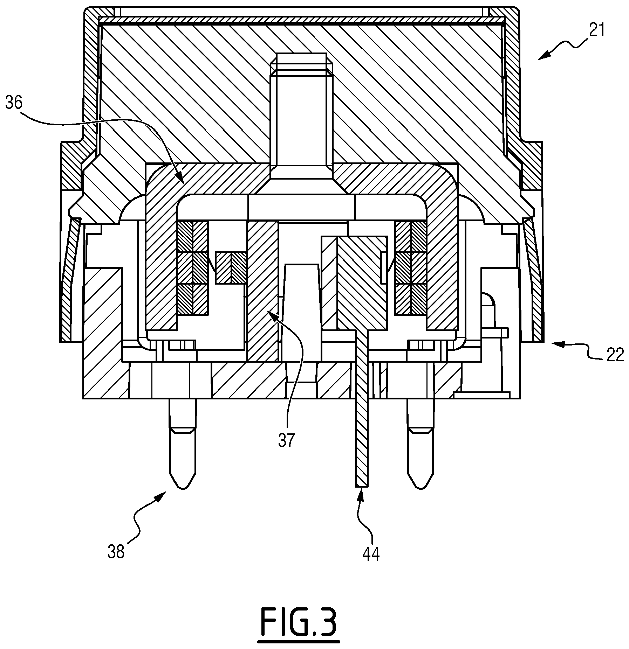

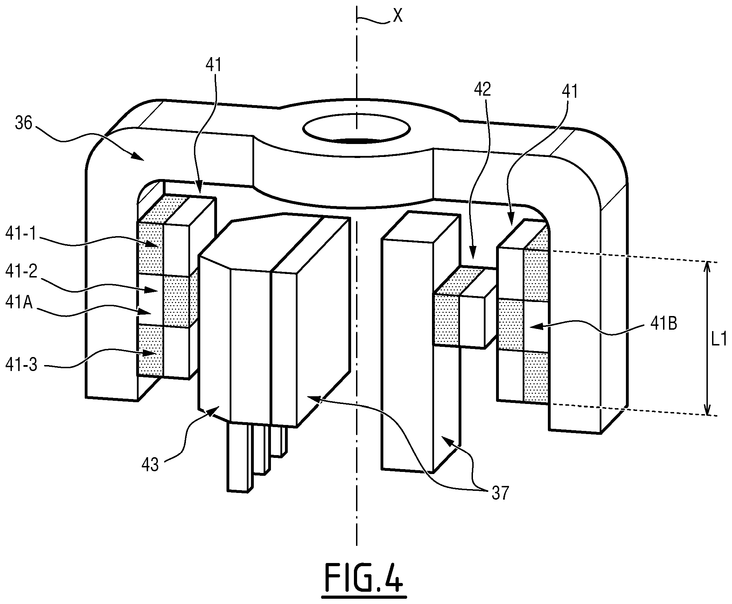

L'élément d'interconnexion 32 est relié de manière solidaire au capot 31. L'élément d'interconnexion 32 comprend un support mobile 36 permettant de maintenir des éléments internes fonctionnels à l'intérieur du corps mobile 21, comme cela sera expliqué en détail par la suite. Le support mobile 36 présente par exemple une pièce magnétique ou ferromagnétique et se présente par exemple sous la forme d'un arc ou d'un « U » surplombant le corps fixe 22 ou au moins certains éléments internes de celui-ci, comme cela est illustré sur la figure 4. En particulier, comme cela est illustré sur les figures 3 et 4, le support mobile 36 peut présenter deux bras de fixation s'étendant sensiblement le long de l'axe de mouvement X et une pièce de raccordement s'étendant sensiblement perpendiculairement à l'axe de mouvement X pour raccorder les deux bras de fixation.

Le corps fixe 22 permet de coopérer avec le corps mobile 21 via les moyens de liaison pour assurer le mouvement du corps mobile 21 le long de l'axe de mouvement X. Le corps fixe 22 comprend un support fixe 37 (visible sur la figure 3) apte à supporter au moins certains des éléments internes fonctionnels coopérant avec les éléments internes fonctionnels du corps mobile 21 comme cela sera expliqué plus en détail par la suite. En particulier, et comme cela sera apparent par la suite, les éléments internes fonctionnels du corps fixe 22 sont maintenus par ce support fixe 37 à distance par rapport à ceux du corps mobile 21. Le support fixe 37 présente par exemple une ou plusieurs pièces magnétiques ou ferromagnétiques s'étendant selon l'axe de mouvement X.

Le corps fixe 22 comprend en outre une surface de fixation 38 permettant de fixer le bouton 10 par exemple à une planche de bord de l'aéronef. La surface de fixation 38 définit par exemple en outre au moins une paire de contact permettant de transmettre des signaux électriques entre le bouton 10 et le système avionique correspondant.

Selon différents modes de réalisation, le corps mobile 21 et/ou le corps fixe 22 peuvent comprendre en outre une butée de course pour chaque fin de course lors du mouvement le long de l'axe de mouvement X. Chaque butée peut être de nature mécanique (i.e. contact mécanique) ou magnétique (via l'usage d'aimants en répulsion en fin de course, par exemple).

En référence à la figure 4, les éléments internes fonctionnels du corps mobile 21 comprennent un élément magnétique 41 et les éléments internes fonctionnels du corps fixe 22 comprennent au moins une dent de crantage 42 apte à coopérer avec l'élément magnétique 41 du corps mobile 21 et au moins un détecteur magnétique 43 apte à générer des mesures quantifiant chaque mouvement du corps mobile 21 selon l'axe de mouvement X.

L'élément magnétique 41 présente une alternance magnétique axiale et est fixé sur le support mobile 36. L'élément magnétique 41 peut présenter toute forme convenable telle que par exemple un anneau, un parallélépipède ou un cylindre ou une portion d'un anneau avec une aimantation axiale ou radiale. En outre, l'élément magnétique 41 peut présenter une seule partie ou plusieurs parties distinctes.

Dans l'exemple de la figure 4, l'élément magnétique 41 se présente sous la forme de deux parties 41A, 41B sensiblement identiques et disposées l'une en regard de l'autre de manière symétrique par rapport à l'axe de mouvement X. Chacune de ces parties 41A, 41B est maintenue par le bras de fixation correspondant du support mobile 36. Sur la même figure, chaque partie 41A, 41B est de forme parallélépipédique s'étendant suivant l'axe de mouvement X.

Pour assurer une alternance magnétique selon l'axe de mouvement X, l'élément magnétique 41 et éventuellement chaque partie distincte 41A, 41B de celui-ci, présente une pluralité de pièces élémentaires magnétiques disposées l'une à côté de l'autre, par exemple par collage. Chaque pièce élémentaire présente par exemple une forme parallélépipédique ou dans le cas d'une forme annulaire de l'élément magnétique 41, un anneau ou un arc d'anneau. Chaque pièce élémentaire présente par exemple un aimant permanent conventionnel ou alors un aimant issu d'un « polyaimants » ou d'un « aimant programmable » nommé Polymagnets^{®}. Dans l'exemple de la figure 4, chaque partie 41A, 41B de l'élément magnétique 41 présente trois pièces élémentaires 41-1, 41-2, 41-3 parallélépipédiques collées l'une à l'autre selon l'axe de mouvement X. Chacune de ces pièces élémentaires 41-1, 41-2, 41-3 présente un aimant permanent définissant le pôle N et le pôle S. Ces pièces sont arrangées le long de l'axe de mouvement X de sorte à former une alternance en pôle N et en pôle S le long de cet axe X. Autrement dit, dans un tel cas, chaque pièce élémentaire présente une aimantation radiale.

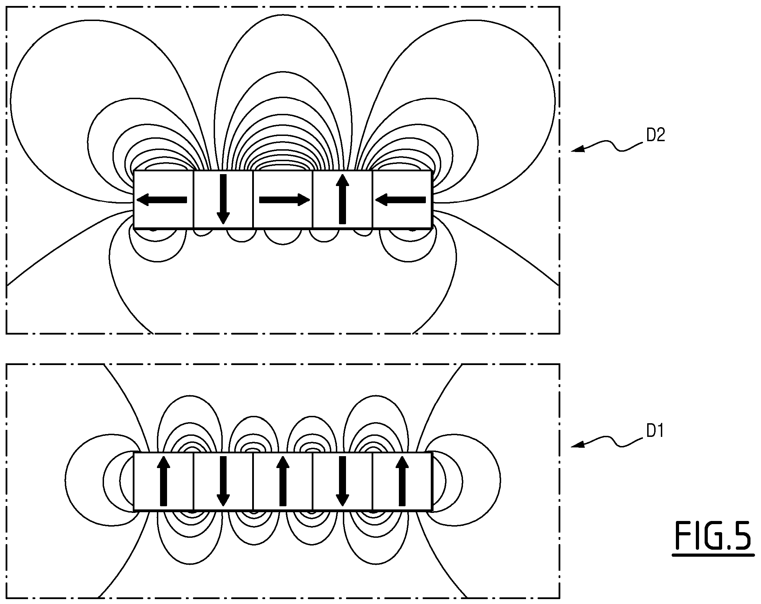

Dans un cas générique, une aimantation radiale est atteinte en disposant chaque pièce élémentaire l'une à côté de l'autre le long de l'axe de mouvement de sorte que les pièces élémentaires adjacentes soient magnétisées dans les sens opposés selon la direction radiale. Cette disposition des pièces élémentaires forme un diagramme D1 des flux magnétiques illustré sur la figure 5 dans le cas de cinq pièces élémentaires.

Selon un autre exemple de disposition possible, une alternance magnétique axiale est atteinte en utilisant un arrangement de type Halbach dont un diagramme D2 des flux magnétiques est illustré également sur la figure 5. En particulier, selon un tel type d'arrangement, les pièces élémentaires sont magnétisées alternativement selon la direction radiale et axiale. Par ailleurs, le sens de la magnétisation de chaque pièce élémentaire est choisi de sorte à concentrer le champ magnétique sur la surface de l'élément magnétique 41 en regard des éléments internes fonctionnels du corps fixe 22.

L'élément magnétique 41 et éventuellement chacune de ses parties 41A, 41B présentent une longueur L1 correspondant à son étendue selon l'axe de mouvement X. Cette longueur L1 définit l'étendue de la course du corps mobile 21. Cette étendue est avantageusement supérieure à 0,9 mm. La longueur L1 est formée d'une somme des largeurs des pièces élémentaires formant cet élément magnétique 41. La largeur de chaque pièce élémentaire forme un pas de crantage. Selon un exemple de réalisation, les pièces élémentaires présentent une même largeur. Dans un tel cas, l'élément magnétique 41 présente un pas de crantage homogène.

Dans l'exemple de la figure 5, trois pièces élémentaires 41-1, 41-2, 41-3 sont arrangées successivement le long de l'axe de mouvement X. Parmi ces pièces élémentaires 41-1, 41-2, 41-3, la pièce élémentaire 41-2 est disposée entre les pièces élémentaires 41-1, 41-3. La pièce élémentaire 41-2 est alors appelée pièce centrale et les pièces élémentaires 41-1, 41-3 sont appelées pièces périphériques. La pièce centrale 41-2 présente alors un cran central et les pièces périphériques 41-1, 41-3 présentent des crans périphériques.

Comme cela est illustré sur la figure 4, le détecteur magnétique 43 est monté sur l'une des pièces formant le support fixe 37 en regard d'au moins l'une des parties de l'élément magnétique 41. Le détecteur magnétique 43 permet de quantifier le déplacement de cet élément magnétique 41 le long de l'axe de mouvement X. Autrement dit, le détecteur 43 permet de coder chaque déplacement de l'élément magnétique 41 le long de l'axe de mouvement X en détectant des changements dans le flux magnétique grâce à l'alternance magnétique axiale des pièces élémentaires constituant l'élément magnétique 41.

Le détecteur magnétique 43 présente par exemple un capteur à effet Hall ou un capteur magnéto-résistif ou un solénoïde. En outre, le détecteur magnétique 43 est relié à un contrôleur externe du bouton 10 par des câbles 44 visibles sur la figure 3 et apte à délivrer à ce contrôleur externe des signaux électriques quantifiant le changement du champ magnétique à proximité du détecteur 43. Ces signaux forment un profil de détection d'activation du bouton. Ce profil comprend au moins un point d'activation correspondant à la détection d'activation du bouton 10, c'est-à-dire une valeur particulière du changement du champ magnétique pour laquelle le bouton 10 est considéré comme activé.

La dent de crantage 42 est montée sur le support fixe 37 par exemple sur une pièce de ce support 37 distincte de celle supportant le détecteur 43. La dent de crantage 42 est montée en regard d'au moins une partie de l'élément magnétique 41. Notamment, la dent de crantage 42 est montée en regard d'au moins une partie de l'élément magnétique 41 par rapport à un plan parallèle à l'axe de mouvement X. En particulier, dans l'exemple de la figure 4, la dent de crantage 42 et le détecteur magnétique 43 sont disposés en regard des parties différentes 41A, 41B de l'élément magnétique 41. La dent de crantage 42 présente une surface qui est orientée vers l'élément magnétique 41 et présente une dimension le long de l'axe de mouvement X inférieure ou égale au pas de crantage défini par l'élément magnétique 41. La dent de crantage 42 est faite d'un matériau ferromagnétique ou magnétique tel que l'inox série 400. La dent de crantage 42 est préférentiellement un aimant. La dent de crantage 42 est par exemple un aimant parallélépipédique ou un aimant en arc de cercle. Un tel aimant est par exemple issu d'un « polyaimant » ou d'un « aimant programmable » nommé Polymagnets^{®}.

La distance entre la dent de crantage 42 et la partie correspondante de l'élément magnétique 41 est adaptée pour assurer un effort de poussée nécessaire. Un tel effort le long de l'axe de mouvement X est par exemple compris de 0,5 à 20 N et avantageusement égal à 5 N. L'effort de poussée peut également être adapté en adaptant le nombre des dents de crantage selon l'axe de mouvement X et/ou autour de l'axe de mouvement X. En outre, avantageusement selon l'invention, la dent de crantage 42 est dans la position stable lorsqu'elle est disposée en regard du cran central, c'est-à-dire en regard de la pièce élémentaire 41-2 de l'élément magnétique 41 dans l'exemple de la figure 4. Pour assurer une telle position stable, la surface en regard de la dent de crantage 42 présente une aimantation opposée à celle de la surface en regard de la pièce élémentaire 41-2 de 41B correspondante.

Il est clair que l'effort poussoir est variable en fonction des positions respectives de la ou de chaque dent de crantage 42 par rapport à l'élément magnétique 41. Pour au moins une position respective particulière de ces éléments, l'effort de poussée présente un pic. Avantageusement, selon l'invention, le point d'activation dans le profil de détection du ou des détecteurs magnétiques 43 est choisi en fonction de ce pic de l'effort de poussée. En particulier, ce point d'activation est avantageusement décalé par rapport au pic de l'effort de poussée de sorte que l'activation du bouton soit détectée après ce pic. Pour atteindre un tel décalage, le détecteur magnétique 43 peut être légèrement décalé le long de l'axe de mouvement X par rapport à la dent de crantage 42.

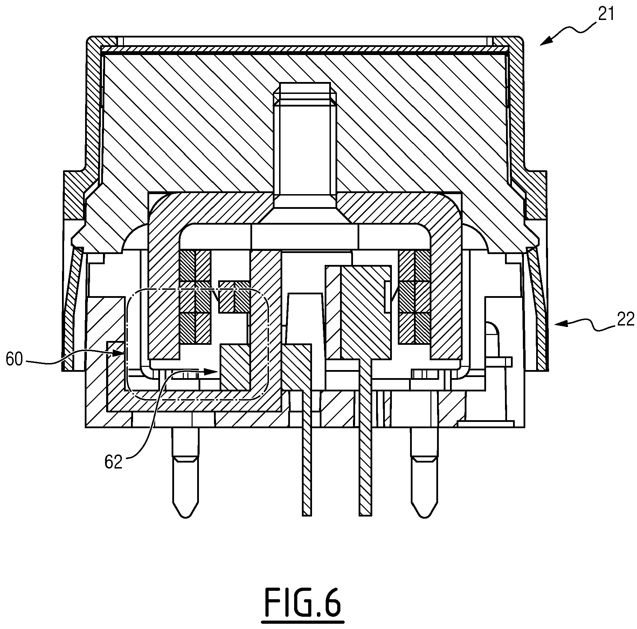

La figure 6 illustre un autre exemple de réalisation du bouton 10. Selon cet exemple, le bouton 10 comprend en outre un contrôleur d'effort complémentaire 60 permettant de contrôler davantage l'effort de poussée selon l'axe de mouvement X. Ce contrôleur 60 comprend notamment une bobine magnétique 62 intégrée dans le corps fixe 22 et apte à créer un champ magnétique permettant d'interagir avec la partie ferromagnétique ou magnétique du corps mobile 21 telle que le support mobile 36, et/ou avec l'élément magnétique 41 du corps mobile 21.

Dans l'exemple de la même figure, le bouton 10 peut comprendre en outre au moins un élément fonctionnel choisi dans la liste comprenant :
- un élément de retour visuel ;
- un capteur de présence ;
- un actionneur haptique.

Un tel élément fonctionnel est par exemple intégré dans la surface visible 35 du capot 31 et/ou être logé dans les cavités de l'élément d'interconnexion 32 illustrées sur la figure 2.

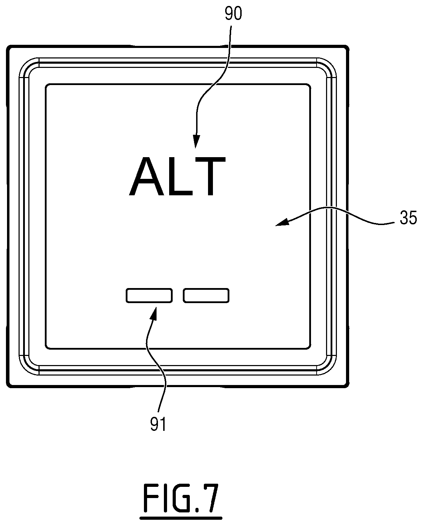

Dans l'exemple de la figure 7, un élément de retour visuel 90 est intégré sur la surface visible 35. L'élément de retour visuel 90 peut par exemple comprendre un indicateur indiquant par exemple la fonction du bouton 10 ou un annonciateur 91 indiquant la validation de la commande ou toute autre lumière d'ambiance.

Cette lumière d'ambiance peut par exemple être connectée au reste du cockpit pour créer une harmonie permettant d'améliorer l'aspect esthétique du bouton 10. En effet, le repérage lumineux en cas d'urgence ou de turbulence peut représenter un atout du point de vue de la sécurité de l'aéronef. Cet éclairage peut être connecté et synchronisé avec le reste du cockpit. Dans ce cas, il pourrait changer de couleur en fonction du contexte durant le vol par exemple clignotement rouge en situation d'urgence.

Lorsque l'élément fonctionnel comprend un capteur de présence, celui-ci peut être intégré dans le bouton 10 pour activer des fonctions complémentaires et/ou pour détecter des positions de doigts sur le bouton. Par exemple, la fonctionnalité du bouton 10 peut être modifiée en fonction du nombre de doigts posés sur la surface visible 35.

Lorsque l'élément fonctionnel comprend un actionneur haptique, celui-ci est préférentiellement placé au bout du bouton 10 pour améliorer le ressenti haptique par l'utilisateur. Il peut présenter un actionneur piézoélectrique ou un moteur de vibration à balourd préférentiellement solidaire du corps fixe 22. L'actionneur peut être aussi un actionneur électromagnétique et agir entre le corps fixe 22 et le corps mobile 21. L'actionneur électromagnétique peut utiliser un enroulement ou une bobine solidaire du corps fixe 22 qui génère un champ magnétique qui attire ou repousse une pièce ferromagnétique ou magnétique suivant l'axe de mouvement X.

Bien entendu, au moins l'un des éléments fonctionnels précités peut être également disposé dans le bouton 10 sans nécessairement le contrôleur d'effort complémentaire 60. Finalement, il doit être compris que la notion d'un premier corps avec tous les éléments associés peut être appliquée à un corps fixe et la notion d'un deuxième corps avec tous les éléments associés peut être appliquée à un corps mobile.

### DEUXIÈME MODE DE RÉALISATION

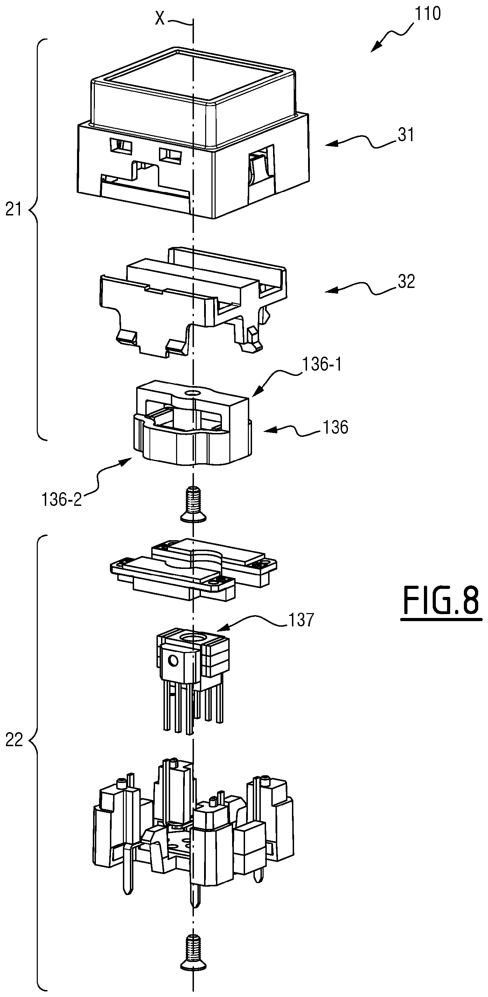

Le deuxième mode de réalisation sera désormais expliqué en référence aux figures 8 à 10. Les éléments similaires avec le premier mode de réalisation sont indiqués sur ces figures par les mêmes références et ne seront pas détaillés ci-dessous.

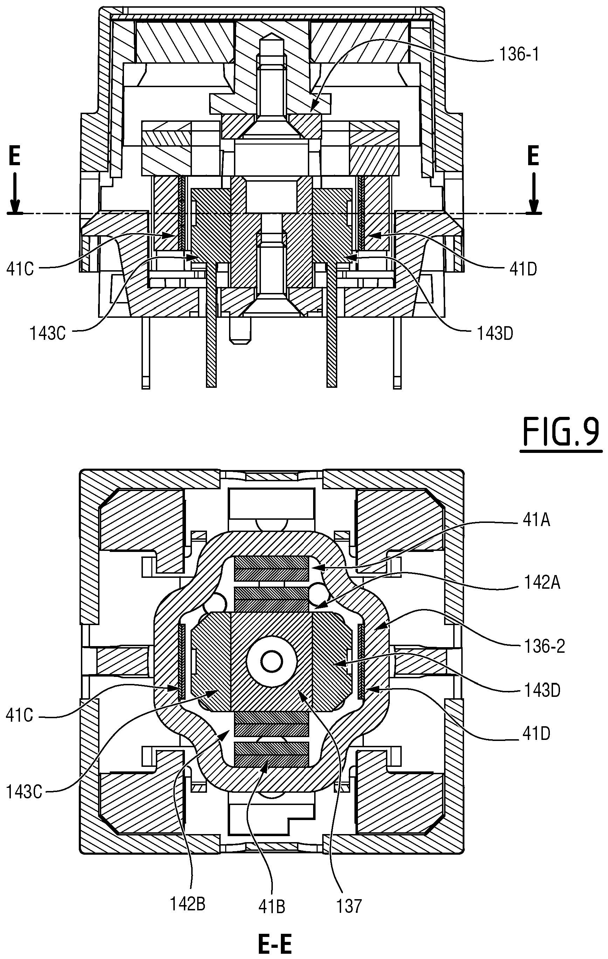

En particulier, et comme cela est illustré sur la figure 8, l'élément d'interconnexion 32 comprend un support mobile 136 qui est différent du support mobile 36 expliqué précédemment. Plus particulièrement, le support mobile 136 est adapté pour maintenir un élément magnétique ayant une structure différente de celui expliqué précédemment. Ainsi, ce support mobile 136 présente une première partie 136-1 en arc ou en « U » qui est analogue au support mobile 36 expliqué précédemment et une deuxième partie 136-2 qui s'étend autour des bras de fixation de la première partie 136-1. Comme dans le cas précédent, chaque bras de fixation reçoit une partie 41A, 41B de l'élément magnétique. Ces parties 41A, 41B sont visibles sur la figure 9 et sont par exemple identiques à celles décrites précédemment. Toutefois, contrairement au cas précédent, chacune de ces parties 41A, 41B est apte à coopérer avec une dent de crantage dédiée. Également contrairement au cas précédent, l'élément magnétique selon le deuxième mode de réalisation comprend en outre deux autres parties 41C, 41D disposées par exemple perpendiculairement à chacune des parties 41A, 41B. Chacune de ces autres parties 41C, 41D de l'élément magnétique est fixée sur la deuxième partie 136-2 du support mobile 136 et est apte à coopérer avec un détecteur magnétique dédié. Chaque partie 41C, 41D peut être analogue à chaque partie 41A, 41B. Selon un exemple de réalisation, les parties 41A à 41D sont reliées entre elles et forment par exemple une forme cylindrique de l'élément magnétique. Selon un autre exemple de réalisation, les parties 41A à 41D sont fixées sur le support mobile 136 autour de l'axe X.

Selon le deuxième mode de réalisation, le corps fixe 22 comprend un support fixe 137 présentant une forme creuse cylindrique s'étendant selon l'axe X. Dans chaque coupe transversale, le support fixe 137 peut présenter un polygone dont le nombre de faces correspond au nombre d'éléments internes fonctionnels du corps fixe 22. Dans l'exemple des figures 8 à 10, ce nombre est égal à 4 et le support fixe 137 présente donc un rectangle (carré par exemple) dans chaque coupe transversale.

Selon le deuxième mode de réalisation, les éléments internes fonctionnels du corps fixe 22 comprennent une pluralité de dents de crantage et/ou une pluralité de détecteurs magnétiques. Dans les exemples des figures, ces éléments internes fonctionnels comprennent deux dents de crantage 142A, 142B disposées en regard des parties 41A, 41B de l'élément magnétique et deux détecteurs magnétiques 143C, 143D disposés en regard des parties 41C, 41D de cet élément magnétique. Ces éléments 41C, 41D, 143C, 143D sont disposés sur les faces correspondantes du support fixe 137 et sont par exemple analogues à ceux décrits précédemment.

De manière générale, les détecteurs magnétiques 143C, 143D et/ou les dents de crantage 142A, 142B peuvent être disposés autour de l'axe de mouvement X. Le doublement, voire le triplement de détecteurs magnétiques et/ou de dents de crantage permet d'améliorer la fiabilité du dispositif, en cas notamment d'un appui asymétrique, i.e. un appui décalé du centre du bouton vers un bord. Dans le cas d'une pluralité de détecteurs magnétiques, le profil de détection d'activation du bouton 10 est formé par exemple par l'ensemble des signaux délivrés par ces détecteurs.

En outre, dans le cas d'une pluralité de détecteurs magnétiques et/ou de dents de crantage, ces éléments peuvent être implémentés selon des technologies différentes et dissemblables, afin de répondre à un niveau DAL élevé (DAL A par exemple). Par exemple, en cas d'une pluralité de détecteurs magnétiques, ces détecteurs peuvent être dissemblables afin de rendre plus fiable la détection.

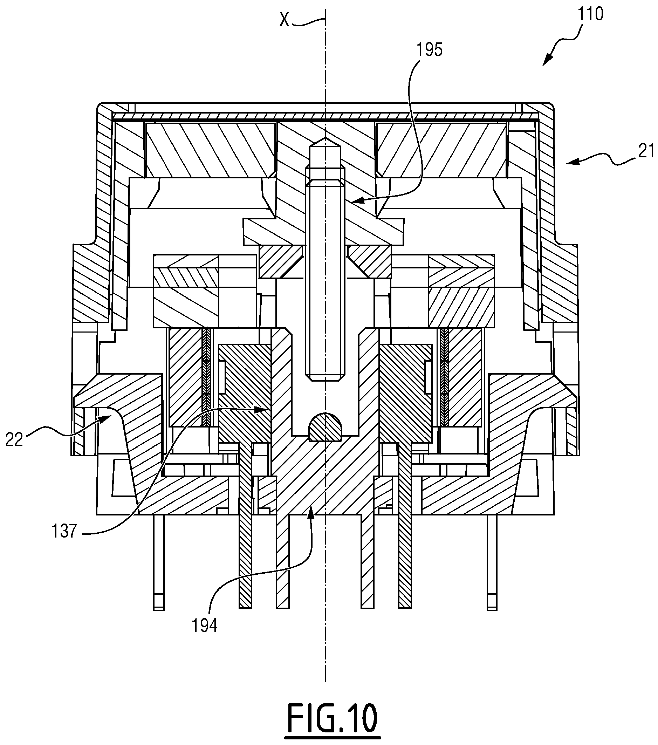

La figure 10 illustre un autre exemple du bouton 110 selon le deuxième mode de réalisation. Selon cet exemple, le bouton 110 comprend en outre un switch 194 intégré au centre du corps fixe 22 (avantageusement dans la partie creuse du support fixe 137) et une tige 195 solidaire du corps mobile 21 et configuré pour coopérer avec le switch 194 lors du mouvement du corps mobile 21 le long de l'axe X. En particulier, la tige 195 est configurée pour coopérer avec le switch 194 lors de l'appui sur bouton 110. Le switch 194 présente donc un moyen redondant aux détecteurs magnétiques permettant de détecter un appui sur le bouton 110.

Avantageusement, le switch 194 est implémenté selon une technologie dissemblable des détecteurs magnétiques. Il est par exemple de nature électromécanique ou opto-mécanique. De préférence, il détecte un appui lors d'un contact mécanique avec la tige 195.

Bien entendu, le switch 194 et la tige 195 peuvent également être implémentés dans le premier mode de réalisation.

## Revendications

1. Bouton poussoir magnétique (10 ; 110) comprenant un corps fixe et un corps mobile par rapport au corps fixe selon un axe de mouvement (X) ;
l'un des corps, dit premier corps (21), comprenant :
- un élément magnétique (41) s'étendant selon l'axe de mouvement (X) et définissant une alternance magnétique selon cet axe de mouvement ;
l'autre corps, dit deuxième corps (22), comprenant :
- une dent de crantage (42 ; 142A, 142B) en matériau ferromagnétique ou magnétique disposée en regard de l'élément magnétique (41) par rapport à un plan parallèle à l'axe de mouvement (X) pour créer un effort de poussée par coopération magnétique avec l'élément magnétique (41), lors d'un mouvement du corps mobile (21) selon l'axe de mouvement (X) ;
- un détecteur magnétique (43 ; 143C, 143D) disposé en regard de l'élément magnétique (41) et configuré pour générer des mesures quantifiant chaque mouvement du corps mobile selon l'axe de mouvement (X).

2. Bouton poussoir magnétique (10 ; 110) selon la revendication 1, dans lequel :
- l'élément magnétique (41) définit au moins un cran central et deux crans périphériques ; et
- une position stable en translation étant définie lorsque la dent de crantage (42 ; 142A, 142B) est disposée en regard du cran central.

3. Bouton poussoir magnétique (10 ; 110) selon l'une quelconque des revendications précédentes, dans lequel l'alternance magnétique de l'élément magnétique (41) définit un pas de crantage.

4. Bouton poussoir magnétique (10 ; 110) selon la revendication 3, dans laquelle la surface de la dent de crantage (42 ; 142A, 142B) présente une étendue inférieure ou égale au pas de crantage de l'élément magnétique (41).

5. Bouton poussoir magnétique (10 ; 110) selon l'une quelconque des revendications précédentes, présentant un profil de détection d'activation du bouton en fonction des mesures générées par le détecteur magnétique (43 ; 143C, 143D) ;
ledit profil de détection comprenant une détection d'activation du bouton avec un décalage par rapport à un pic de l'effort de poussée créé par coopération magnétique de l'élément magnétique (41) avec la dent de crantage (42 ; 142A, 142B).

6. Bouton poussoir magnétique (10 ; 110) selon la revendication 5, dans lequel ledit décalage dans le profil de détection est atteint par un décalage le long de l'axe de mouvement (X) du détecteur magnétique (43 ; 143C, 143D) et de la dent de crantage (42).

7. Bouton poussoir magnétique (110) selon l'une quelconque des revendications précédentes, dans lequel le deuxième corps (22) comprend une pluralité de dents de crantage (142A, 142B) et/ou une pluralité de détecteurs magnétiques (143C, 143D) réparties de manière équidistante selon l'axe de mouvement (X) et/ou autour de l'axe de mouvement (X).

8. Bouton poussoir magnétique (10 ; 110) selon l'une quelconque des revendications précédentes, dans lequel le ou chaque dent de crantage (42 ; 142A, 142B) et/ou l'élément magnétique (41) est (sont) monté(e)(s) sur un support (36, 37 ; 136, 137) magnétique ou ferromagnétique.

9. Bouton poussoir magnétique (10 ; 110) selon l'une quelconque des revendications précédentes, dans lequel le premier corps (21) est le corps mobile et le deuxième corps (22) est le corps fixe.

10. Bouton poussoir magnétique (10 ; 110) selon l'une quelconque des revendications précédentes, comprenant en outre une butée de course pour chaque fin de course lors du mouvement le long de l'axe de mouvement (X).

11. Bouton poussoir magnétique (10 ; 110) selon l'une quelconque des revendications précédentes, comprenant en outre une surface (35) destinée à être orientée vers un opérateur ;
ladite surface (35) comprenant au moins un élément fonctionnel (90) choisi dans la liste comprenant :
- un élément de retour visuel ;
- un capteur de présence ;
- un actionneur haptique.

12. Bouton poussoir magnétique (10 ; 110) selon l'une quelconque des revendications précédentes, comprenant en outre un contrôleur d'effort (60) complémentaire comprenant une bobine électromagnétique (62) solidaire de l'un des corps (21, 22) et configurée pour agir sur la ou chaque dent de crantage (42) et/ou sur l'élément magnétique (41) et/ou sur un support ferromagnétique ou magnétique (36, 37).

13. Bouton poussoir magnétique (10 ; 110) selon l'une quelconque des revendications précédentes, comprenant en outre un switch (194) électromécanique ou opto-mécanique supplémentaire placé au centre du deuxième corps (22) et configuré pour être activé par une tige (195) solidaire du premier corps (21).

## Patentansprüche

1. Magnetischer Druckknopf (10; 110), umfassend einen festen Körper und einen Körper, der in Bezug auf den feststehenden Körper entlang einer Bewegungsachse (X) bewegbar ist;
wobei einer der Körper, der sogenannte erste Körper (21), Folgendes umfasst:
- ein magnetisches Element (41), das sich entlang der Bewegungsachse (X) erstreckt und eine magnetische Wechselwirkung entlang dieser Bewegungsachse definiert;
der andere Körper, der sogenannte zweite Körper (22), Folgendes umfasst:
- eine Rastnase (42; 142A, 142B) aus ferromagnetischem oder magnetischem Material, die gegenüber dem magnetischen Element (41) in Bezug auf eine Ebene parallel zu der Bewegungsachse (X) angeordnet ist, um bei einer Bewegung des bewegbaren Körpers (21) entlang der Bewegungsachse (X) durch magnetisches Zusammenwirken mit dem magnetischen Element (41) eine Schubkraft zu erzeugen;
- einen magnetischen Detektor (43; 143C, 143D), der gegenüber dem magnetischen Element (41) angeordnet und konfiguriert ist, um Messungen zu erzeugen, die jede Bewegung des bewegbaren Körpers entlang der Bewegungsachse (X) zu quantifizieren.

2. Magnetischer Druckknopf (10; 110) nach Anspruch 1, wobei:
- das magnetische Element (41) mindestens eine mittlere Kerbe und zwei periphere Kerben definiert; und
- eine translationsstabile Position definiert ist, wenn die Rastnase (42; 142A, 142B) gegenüber der mittleren Kerbe angeordnet ist.

3. Magnetischer Druckknopf (10; 110) nach einem der vorherigen Ansprüche, wobei die magnetische Wechselwirkung des magnetischen Elements (41) einen Rastabstand definiert.

4. Magnetischer Druckknopf (10; 110) nach Anspruch 3, wobei die Oberfläche der Rastnase (42; 142A, 142B) eine Erstreckung aufweist, die kleiner als oder gleich wie der Rastabstand des magnetischen Elements (41) ist.

5. Magnetischer Druckknopf (10; 110) nach einem der vorherigen Ansprüche, der ein Erkennungsprofil einer Betätigung des Knopfs abhängig von auf den Messungen aufweist, die von dem Magnetsensor (43; 143C, 143D) erzeugt werden;
das Erfassungsprofil umfassend eine Erkennung einer Betätigung des Knopfs mit einer Verschiebung in Bezug auf eine Spitze der Druckkraft, die durch magnetisches Zusammenwirken des magnetischen Elements (41) mit der Rastnase (42; 142A, 142B) erzeugt wird.

6. Magnetischer Druckknopf (10; 110) nach Anspruch 5, wobei die Verschiebung in dem Erkennungsprofil durch eine Verschiebung des magnetischen Detektors (43; 143C, 143D) und der Rastnase (42) entlang der Bewegungsachse (X) erreicht wird.

7. Magnetischer Druckknopf (110) nach einem der vorherigen Ansprüche, wobei der zweite Körper (22) eine Vielzahl von Rastnasen (142A, 142B) und/oder eine Vielzahl von magnetischen Detektoren (143C, 143D) umfasst, die in gleichen Abständen entlang der Bewegungsachse (X) und/oder um die Bewegungsachse (X) herum verteilt sind.

8. Magnetischer Druckknopf (10; 110) nach einem der vorherigen Ansprüche, wobei die oder jede Rastnase (42; 142A, 142B) und/oder das magnetische Element (41) auf einem magnetischen oder ferromagnetischen Träger (36, 37; 136, 137) montiert ist bzw. sind.

9. Magnetischer Druckknopf (10; 110) nach einem der vorherigen Ansprüche, wobei der erste Körper (21) der bewegbare Körper ist und der zweite Körper (22) der feststehende Körper ist.

10. Magnetischer Druckknopf (10; 110) nach einem der vorherigen Ansprüche, ferner umfassend einen Hubanschlag für jeden Endanschlag bei der Bewegung entlang der Bewegungsachse (X).

11. Magnetischer Druckknopf (10; 110) nach einem der vorherigen Ansprüche, ferner umfassend eine Fläche (35), die dazu bestimmt ist, auf einen Bediener ausgerichtet zu sein;
die Fläche (35) umfassend mindestens ein funktionelles Element (90), das ausgewählt ist aus der Liste, umfassend:
- ein Element für visuelles Feedback;
- einen Präsenzsensor;
- einen haptischen Aktuator.

12. Magnetischer Druckknopf (10; 110) nach einem der vorherigen Ansprüche, ferner umfassend eine komplementäre Kraftsteuerung (60), umfassend eine elektromagnetische Spule (62), die fest mit einem der Körper (21, 22) verbunden und konfiguriert ist, um auf die oder jede Rastnase (42) und/oder auf das magnetische Element (41) und/oder auf einen ferromagnetischen oder magnetischen Träger (36, 37) zu wirken.

13. Magnetischer Druckknopf (10; 110) nach einem der vorherigen Ansprüche, ferner umfassend einen zusätzlichen elektromechanischen oder optomechanischen Schalter (194), der in der Mitte des zweiten Körpers (22) platziert und konfiguriert ist, um durch eine Stange (195) aktiviert zu werden, die fest mit dem ersten Körper (21) verbunden ist.

## Claims

1. A magnetic push-button (10; 110) comprising a fixed body and a movable body, movable relative to the fixed body along an axis of movement (X);
one of the bodies, called first body (21), comprising:
- a magnetic element (41) extending along the axis of movement (X) and defining a magnetic alternation along the axis of movement;
the other body, called second body (22), comprising:
- a notching tooth (42; 142A, 142B) made of ferromagnetic or magnetic material arranged opposite the magnetic element (41) with respect to a plane parallel to the axis of movement (X) in order to generate a push force by magnetic cooperation with the magnetic element (41), during a movement of the movable body (21) along the axis of movement (X);
- a magnetic detector (43; 143C, 143D) arranged opposite the magnetic element (41) and configured for generating measurements quantifying each movement of the movable body along the axis of movement (X).

2. The magnetic push-button (10; 110) according to claim 1, wherein:
- the magnetic element (41) defines at least one central notch and two peripheral notches; and
- a position which is stable in translation is defined when the notching tooth (42; 142A, 142B) is arranged opposite the central notch.

3. The magnetic push-button (10; 110) according to any of the preceding claims, wherein the magnetic alternation of the magnetic element (41) defines a notching pitch.

4. The magnetic push-button (10; 110) according to claim 3, wherein the surface of the notching tooth (42; 142A, 142B) has an extent less than or equal to the notching pitch of the magnetic element (41).

5. The magnetic push-button (10; 110) according to any of the preceding claims, having a detection profile for the button activation according to the measurements generated by the magnetic sensor (43; 143C, 143D);
said detection profile comprising a detection of activation of the button with an offset with respect to a peak of the push force generated by magnetic cooperation of the magnetic element (41) with the notching tooth (42; 142A, 142B).

6. The magnetic push-button (10; 110) according to claim 5, wherein said offset in the detection profile is achieved by an offset along the axis of movement (X) of the magnetic sensor (43; 143C, 143D) and of the notching tooth (42).

7. The magnetic push-button (110) according to any of the preceding claims, wherein the second body (22) comprises a plurality of notching teeth (142A, 142B) and/or a plurality of magnetic sensors (143C, 143D) distributed equidistantly along the axis of movement (X) and/or about the axis of movement (X).

8. The magnetic push-button (10; 110) according to any of the preceding claims, wherein the or each notching tooth (42; 142A, 142B) and/or the magnetic element (41) is mounted on a magnetic or ferromagnetic support (36, 37; 136, 137).

9. The magnetic push-button (10; 110) according to any of the preceding claims, wherein the first body (21) is the movable body and the second body (22) is the fixed body.

10. The magnetic push-button (10; 110) according to any of the preceding claims, further comprising a travel stop for each end of travel during the movement along the axis of movement (X).

11. The magnetic push-button (10; 110) according to any of the preceding claims, further comprising a surface (35) intended for being oriented towards an operator;
the surface (35) comprising at least one functional element (90) selected from the list comprising:
- an element of visual feedback;
- a presence sensor;
- a haptic actuator.

12. The magnetic push-button (10; 110) according to any of the preceding claims, further comprising a supplementary force controller (60) comprising an electromagnetic coil (62) rigidly attached to one of the bodies (21, 22) and configured for acting on the or each notching tooth (42) and/or on the magnetic element (41) and/or on a ferromagnetic or magnetic support (36, 37).

13. The magnetic push-button (10; 110) according to any of the preceding claims, further comprising an additional electromechanical or opto-mechanical switch (194) placed in the center of the second body (22) and configured for being activated by a rod (195) rigidly attached to the first body (21).
